# EUROPEAN PATENT APPLICATION

(11) **EP 4 546 430 A1**
(43) Date of publication of application: **30.04.2025**
(21) Application number: 24184287.1
(22) Date of filing: 25.06.2024
(51) Int. Cl.: H01L 29/423, H10B 41/30, H01L 21/28

(54) **NON-VOLATILE MEMORY DEVICE**

(30) Priority: 24.10.2023 US 202363545368 P; 22.03.2024 US 202418613138
(71) Applicant: Iotmemory Technology Inc., Taipei City 105 (TW)
(72) Inventor: FAN, Der-Tsyr, 320 Taoyuan City (TW); HUANG, I-Hsin, 338 Taoyuan City (TW); CHENG, Tzung-Wen, 235 New Taipei City (TW); CHENG, Yu-Ming, 261 Yilan County (TW); TSAI, Chen-Ming, 350 Miaoli County (TW)
(74) Representative: Straus, Alexander

(57) **Abstract**

A non-volatile memory device includes at least one memory cell, and the memory cell includes a substrate, a trench, an erase gate, a control gate, and a floating gate. The trench is disposed in the substrate. The erase gate is disposed in the trench and includes a concave corner. The control gate is disposed on the substrate, and a bottom surface of the control gate is higher than a bottom surface of the erase gate. The floating gate is disposed on the substrate, and the floating gate includes a lower tip pointing toward the concave corner of the erase gate and extending beyond a sidewall of the trench.

## Description

### Field of the Invention

The present invention relates to a non-volatile memory device with a floating gate according to the pre-characterizing clause of claim 1.

### Background of the Invention

A conventional structure of non-volatile memory has a stack-gate structure, including a tunneling oxide layer, a floating gate, a coupling dielectric layer, and a control gate disposed on a substrate in order. When a programming or erase operation is performed on such a flash memory device, a suitable voltage is respectively applied to the source region, the drain region, and the control gate, such that electrons are injected into a floating gate, or electrons are pulled out from the floating gate.

In the programming and erase operation of the non-volatile memory, a greater gate-coupling ratio (GCR) between the floating gate and the control gate generally means a lower operating voltage is needed for the operation, and the operating speed and the efficiency of the flash memory are significantly increased as a result. However, during programming or erase operations, electrons have to be injected into or pulled out of the floating gate through a tunneling oxide layer disposed under the floating gate, which often causes damages to the structure of the tunneling oxide layer and thus reduces the reliability of the memory device.

In order to increase the reliability of the memory device, an erase gate is adopted and incorporated into to the memory device, which is capable of pulling the electrons from the floating gate by applying a positive voltage to the erase gate. Thus, since the electrons in the floating gate is pulled out through a tunneling oxide layer disposed on the floating gate rather than through the tunneling oxide layer disposed under the floating gate, the reliability of the memory device is further improved.

The above-mentioned memory devices, along with logic devices such as transistors with planar gate structures, are typically integrated and fabricated together on the same wafer. The memory device is usually taller than the logic device because the memory device includes a stacked gate structure including a select gate and an erase gate.

During the fabrication of middle-end-of-line (MEOL) structures, a blanket interlayer dielectric (ILD) layer is formed to cover both the logic device and the memory device. Typically, after performing a planarization process on the interlayer dielectric (ILD) layer, the ILD layer above the memory device is thinner than the ILD above the logic device because of the presence of the stacked gate structure in the memory device.

To further miniaturize the line widths of all the contact plugs formed within the ILD layer, it is necessary to reduce the thickness of the ILD layer covering both the logic device and the memory device. However, if the ILD layer above the memory device becomes too thin, it may lead to unintended electrical coupling between the memory device and the interconnects above it, which adversely affects the electrical performance of the memory device.

Therefore, there remains a need for an improved structural design of memory devices.

### Summary of the Invention

This is in mind, the present invention aims at providing a non-volatile memory device that has a reduced height which is suitable to be integrated with logic devices.

This is achieved by a non-volatile memory device according to claim 1. The dependent claims pertain to further developments and improvements.

As will be seen more clearly from the detailed description below, the claimed non-volatile memory device includes a substrate, a trench, an erase gate, a control gate, and a floating gate. The trench is disposed in the substrate. The erase gate is disposed in the trench and includes a concave corner. The control gate is disposed on the substrate, and a bottom surface of the control gate is higher than a bottom surface of the erase gate. The floating gate is disposed on the substrate, and the floating gate includes a lower tip pointing toward the concave corner of the erase gate and extending beyond a sidewall of the trench.

### Brief Description of the Drawings

In the following, the invention is further illustrated by way of example, taking reference to the accompanying drawings. Thereof:
FIG. 1 is a schematic top view of a non-volatile memory device according to some embodiments of the present disclosure.
FIG. 2 is a schematic cross-sectional view of a non-volatile memory device taken along line A-A' of FIG. 1 according to some embodiments of the present disclosure.
FIG. 3 is an enlarged cross-sectional view corresponding to a region R1 of FIG. 2.
FIG. 4 is a schematic cross-sectional view of a non-volatile memory device taken along line B-B' of FIG. 1 according to some embodiments of the present disclosure.
FIG. 5 is a schematic cross-sectional view of a non-volatile memory device taken along line B-B' of FIG. 1 according to an alternative embodiment of the present disclosure.
FIG. 6 is a schematic cross-sectional view of a non-volatile memory device taken along line C-C' of FIG. 1 according to some embodiments of the present disclosure.
FIG. 7 is a schematic cross-sectional view of a non-volatile memory device according to an alternative embodiment of the present disclosure.
FIG. 8 is a schematic cross-sectional view of a non-volatile memory device according to an alternative embodiment of the present disclosure.
FIG. 9 is a schematic cross-sectional view of a non-volatile memory device according to an alternative embodiment of the present disclosure.
FIG. 10 to FIG. 15 are cross-sectional views at various stages in the manufacturing of non-volatile memory devices according to some embodiments of the present disclosure.
FIG. 16 is a schematic cross-sectional view at various stages in the manufacturing of non-volatile memory devices according to an alternative embodiment of the present disclosure.

### Detailed Description

The following disclosure provides many different embodiments, or examples, for implementing different features of the disclosure. Specific examples of components and arrangements are described below to simplify the present disclosure. These are, of course, merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed.

Further , spatially relative terms, such as "beneath", "below", "lower", "under", "on", "over", "above", "upper", "bottom", "top" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. For example, if the device in the figures is turned over, elements described as "below" and/or "under" other elements or features would then be oriented "above" and/or "over" the other elements or features. The apparatus may be otherwise oriented (rotated 90 degrees or at other orientations) and the spatially relative descriptors used herein may likewise be interpreted accordingly.

Although the disclosure is described with respect to specific embodiments, the principles of the disclosure, as defined by the claims appended herein, may obviously be applied beyond the specifically described embodiments of the disclosure described herein. Moreover, in the description of the present disclosure, certain details have been left out in order to not obscure the inventive aspects of the disclosure. The details left out are within the knowledge of a person having ordinary skill in the art.

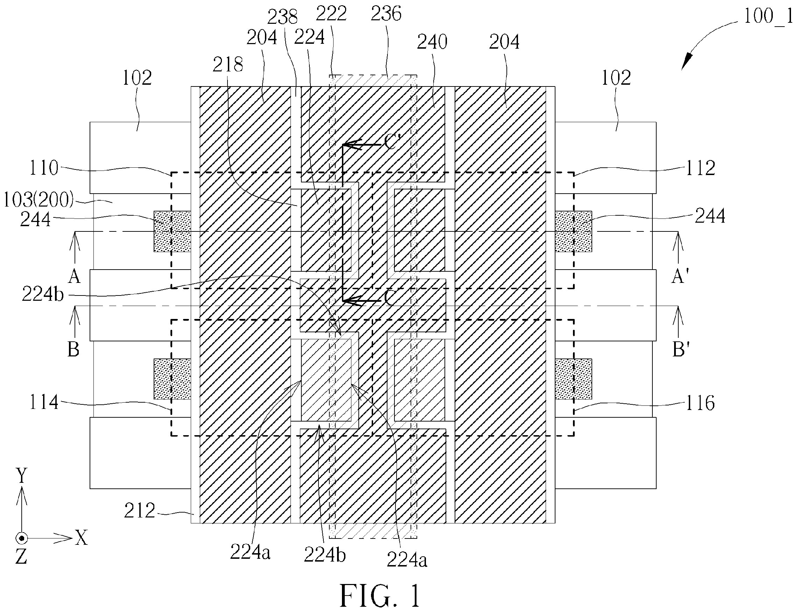

FIG. 1 is a schematic top view of a non-volatile memory device according to some embodiments of the present disclosure. Referring to FIG. 1, a non-volatile memory device 100_1 can be a NOR flash memory device including at least one memory cell, such as four memory cells accommodated in the first, second, third, and fourth memory cell regions 110, 112, 114, and 116, respectively. The structures in the first memory cell region 110 and the second memory cell region 112 have a mirror image of each other, and the structures in the third memory cell region 114 and the fourth memory cell region 116 have a mirror image of each other. According to one embodiment of the present disclosure, the non-volatile memory device 100 includes more than four memory cells, and these memory cells can be arranged in an array with numerous rows and columns.

Referring to FIG. 1, the non-volatile memory device includes a substrate 200 and an isolation structure 102. The substrate 200 can be a semiconductor substrate 200, such as a silicon substrate or silicon-on-insulator (SOI) substrate, but not limited thereto. The isolation structure 102 can be made an insulating material and is used to define active areas 103 of the memory cells.

Each of the memory cells includes a source region 222 and a drain region 244 disposed in the active area 103 defined by the isolation structure 102. The source region 222 and the drain region 244 can be doped regions of the same conductivity type, such as n-type or p-type. The conductivity type of the source region 222 and the drain region 244 is different from the conductivity type of the substrate 200, or different from the conductivity type of a doped well (not shown) used to accommodate the source region 222 and the drain region 244. The source region 222 can be disposed at one end of the active area 103, and the drain region 244 can be arranged at another end of the active area 103. According to some embodiments of the present disclosure, the source region 222 is a continuous region extending along a Y-direction and shared by the memory cells in the same column.

Each memory cell can further include a select gate 204 disposed on the substrate 200 and adjacent to the drain region 244. The select gate 204 can extend along the Y-direction and shared by the memory cells that are located in the same column. The select gate 204 can be made of conductive material such as poly silicon or metal, and select gate 204 can act as a word line configured to turn on/off the corresponding channel regions of the memory cells arranged in the same column.

A dielectric spacer 212 can be disposed on the sidewalls of the select gate 204 in order to insulate the select gate 204 from other conductive components. The dielectric spacer 212 can be a single-layered, double-layered, or a multi-layered spacer disposed on each sidewall of the select gate 204, but not limited thereto.

Each memory cell also includes a floating gate 224 disposed on the substrate 200 and adjacent to the source region 222. Thus, the floating gate 224 is disposed at one side of the select gate 204 and opposite the drain region 244 (i.e. the other side of the select gate 204 that is adjacent to the drain region 244). The floating gates 224 are made of conductive material, such as polysilicon or other semiconductor. The floating gates 224 are spaced apart from each other so that the electric current is not directly transmitted between the floating gates 224. Each floating gate 224 may include two opposite first sidewalls 224a and two opposite second sidewalls 224b. The first sidewalls 224a are arranged along a first direction (i.e. the X-direction), and the second sidewalls 224b are opposite each other and arranged along a second direction (i.e. the Y-direction) different from the first direction (i.e. the X-direction).

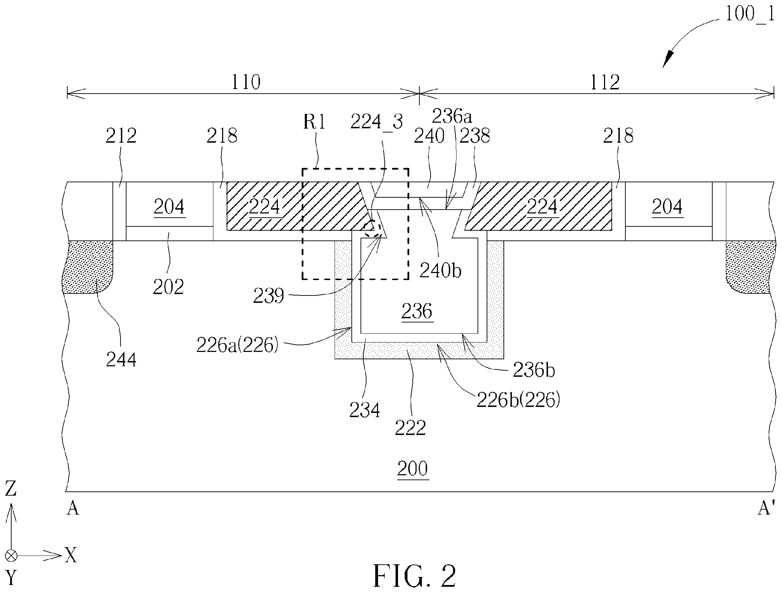

Since the floating gates 224 are spaced apart from each other, each the floating gate 224 can be programed or erased independently to thereby determine the state of each memory cell, such as state "1" or state "0". As shown in the following cross-sectional views, such as FIG. 2, FIG. 6 and FIG. 7, each floating gate 224 may be a bar-shaped structure, an L-shaped structure, or a structure with a curved sidewall. The detailed cross-sectional structure of the floating gate 224 is described in the description corresponding to FIG. 2, FIG. 6 and FIG. 7.

A floating gate dielectric layer 218 is disposed at least between the first sidewall 224a of the floating gate 224 and the select gate 204. The floating gate dielectric layer 218 also extends below the floating gate 224, which allows hot electrons to be injected into the floating gate 224 during a programming operation. The material of the floating gate dielectric layer 218 is, for instance, silicon oxide or other materials.

During a programming operation, hot electrons are allowed to pass through the floating gate dielectric layer 218 and accumulate in the corresponding floating gate 224.

Referring to FIG. 1, each memory cell also includes a control gate 240 disposed on the substrate 200 and extending along the Y-direction. Three sidewalls (i.e. one first sidewall 224a and two second sidewalls 224b) of the floating gates 224 can be covered with the control gate 240. The control gate 240 is disposed in the gap between opposite select gates 204 and extends along the Y-direction. The control gate 240 can be shared by a pair of memory cells arranged in the same row. For example, the control gate 240 can be shared by the memory cells accommodated in the first and second memory cell regions 110, 112, respectively. The control gate 240 can cover the continuous source region 222 in a top view. The control gate 240 is made of conductive material such as polysilicon, metal or other conductive semiconductor, but is not limited thereto.

The purpose of the control gate 240 is to make hot carriers (e.g. electrons) injected from the channel into the floating gate 224. For example, when a suitable positive voltage is applied to the control gate 240, hot carriers (e.g. electrons) transmitted in the carrier channel under the floating gate 224 can be injected to and accumulated in the corresponding floating gate 224.

A coupling dielectric layer 238 is disposed between the control gate 240 and the floating gate 224. Thus, the sidewall of the select gate 204 that faces the control gate 240 may be covered with the coupling dielectric layer 238. Also, three sidewalls (i.e. one first sidewall 224a and two second sidewall 224b) of each floating gate 224 may be covered with the coupling dielectric layer 238. The coupling dielectric layer 238 can be a single dielectric including silicon oxide or oxynitride, or composite dielectric layer including silicon oxide/silicon nitride/silicon oxide, but is not limited thereto.

The non-volatile memory device 100 further includes an erase gate 236 extending along the Y-direction. The erase gate 236 can be a continuous layer disposed in a trench (not shown) formed in the substrate 200. Thus, when viewed from a top-down perspective, the erase gate 236 is covered with both the control gate 240 and the floating gate 224. Besides, the erase gate 236 is laterally spaced apart from the select gate 204, and does not overlap the select gate 204 when viewed from a top-down perspective. In an erasing operation of the non-volatile memory 100_1, the erase gate 236 is biased, which causes the electrons stored in the floating gate 224 to be pulled out mainly through a lower tip (not shown)of the floating gate 224.

FIG. 2 is a schematic cross-sectional view of a non-volatile memory device taken along line A-A' of FIG. 1 according to some embodiments of the present disclosure. The configuration shown in FIG. 2 includes a first memory cell and a second memory cell accommodated in a first memory cell region 110 and a second memory cell region 112, respectively. Each of the first memory cell region 110 and the second memory cell region 112 includes at least the erase gate 236, the control gate 240 and the floating gate 224. The source region 222 is shared by the first memory cell region 110 and the second memory cell region 112. In some embodiments, the first memory cell and the second memory cell have a mirror image of each other.

Referring to FIG. 2, the non-volatile memory device includes a trench 226 disposed in the substrate 200. The trench 226 extends along a second direction (i.e., the Y-direction) and is used to accommodate the erase gate 236. The source region 222 is in direct contact with the trench 226 and disposed along a sidewall 226a and bottom surface 226a of the trench 226. When viewed from above such as in FIG. 1, both the source region 222 and the trench 226 may extend along the same direction (i.e., the Y-direction).

An erase gate dielectric layer 234 is a conformal layer disposed on the inner surface of the trench 226. In other words, the erase gate dielectric layer 234 is disposed on the sidewall 226a and bottom surface 226b of the trench 226. The erase gate dielectric layer 234 is disposed between the lower tip 224_3 of the floating gate 224 and the erase gate 236 and is made of dielectric layer, which allows electrons originally stored in the floating gate 224 to pass through it by Fowler-Nordheim (FN) tunneling mechanism.

The erase gate 236 is located in the trench 226, and a top surface of the erase gate 236 is higher than a top surface of the substrate 200. The erase gate 236 includes a concave corner 239 which is formed corresponding to a lower tip 224_3 of the floating gate 224. The lower tip 224_3 of the floating gate 224 may extend beyond the sidewall 226a of the trench 226 and point toward the concave corner 239 of the erase gate 236. In this configuration, the lower tip 224_3 of the floating gate 224 appears to be partially wrapped around by the concave corner 239 of the erase gate 236. Due to the presence of the lower tip 224_3, during an erase operation of the non-volatile memory device 100_1, electrons originally stored in the floating gate 224 can be pulled out more effectively through the lower tip 224_3 by biasing the erase gate 254.

The control gate 240 covers the top surface 236a of the erase gate 236, and a bottom surface 240b of the control gate 240 is higher than a bottom surface 236b of the erase gate 236. The control gate 240 and the underlying erase gate 236 are separated by the coupling dielectric layer 238.

The coupling dielectric layer 238 is a continuous layer that extends from below the control gate 240 to a region between the control gate 240 and the floating gate 224. Therefore, a portion of the coupling dielectric layer 238 is disposed between the top surface 236a of the erase gate 236 and a bottom surface of the control gate 240.

The floating gate dielectric layer 218 is initially an L-shaped structure including a vertical portion and a horizontal portion. The vertical portion of the floating gate dielectric layer 218 is disposed between the floating gate 224 and the select gate 204, and the horizontal portion of the floating gate dielectric layer 218 is disposed between the floating gate 224 and the substrate 200.

The select gate 204 is laterally spaced apart from the erase gate 236 and the control gate 240. In this embodiment, the top surface of the select gate 204 is higher than the top surface 236a of the erase gate 236. The select gate 204 can be made of conductive material such as poly silicon or metal, and the select gate 204 can act as a word line configured to turn on/off the channel regions of the memory cells arranged in the same column.

A gate dielectric layer 202 is disposed between the select gate 204 and the substrate 200, and the gate dielectric layer 202 and the select gate 204 are the components of a select gate structure.

Still referring to FIG. 2, a planarization process can be performed on the select gate 204, the control gate 240, and the floating gate during the manufacturing of the non-volatile memory device. Consequently, a top surface 204a of the select gate 204, a top surface 240a of the control gate 240, and a top surface 225 of the floating gate 224 are substantially level with each other.

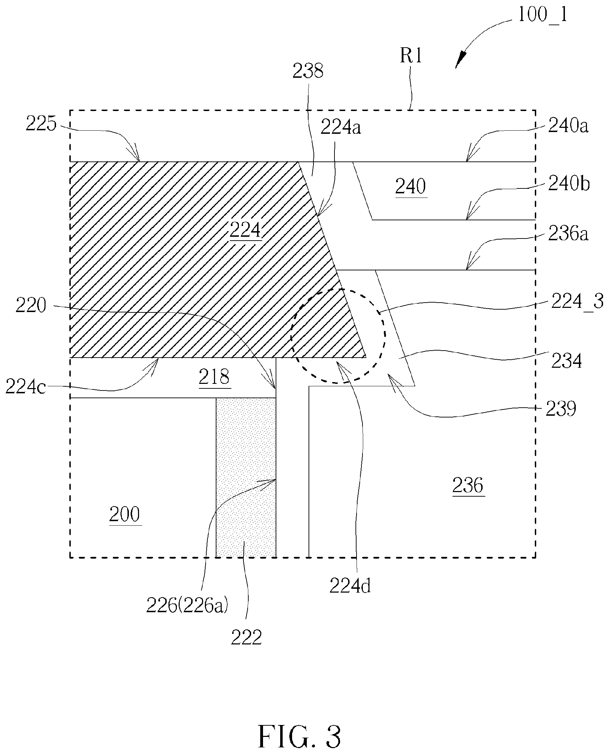

FIG. 3 is an enlarged cross-sectional view corresponding to region R1 of FIG. 2. Referring to FIG. 3, in region R1, the lower tip 224_3 of the floating gate 224 that points toward the concave corner 239 of the erase gate 236 is disposed over the trench 226. The lower tip 224_3 and the erase gate 236 are separated by the erase gate dielectric layer 234. Specifically, a bottom surface 224a and sidewall (i.e. a lower portion of the first sidewall 224a) of the lower tip 224_3 are in direct contact with the erase gate dielectric layer 234. The erase gate dielectric layer 234 may conform to the shape of the lower tip 224_3.

The coupling dielectric layer 238 is located above the erase gate dielectric layer 234 and the erase gate 236. Specifically, a portion of the coupling dielectric layer 238 is sandwiched between the top surface 236a of the erase gate 236 and the bottom surface 240b of the control gate 240.

The floating gate dielectric layer 218 is disposed between the floating gate 224 and the substrate 200, and an end portion 220 of the floating gate dielectric layer 218 is in direct contact with the erase gate dielectric layer 234. Although the edge of the end portion 220 shown in FIG. 3 is substantially aligned with the sidewall 226a of the trench 226, the edge of the end portion 220 may be misaligned with the sidewall 226a. In this case, a portion of the erase gate dielectric layer 234 may be filled into the gap between the floating gate 224 and the substrate 200.

In some embodiments, the bottom surface 224c of the floating gate 224 is higher than the bottom surface of the erase gate 236. The top surface 225 of the floating gate 224 is higher than the top surface 236a of the erase gate 236, and is level with the top surface 240a of the control gate 240. Because the top surface 225 of the floating gate 224 does not overlap the top surface 240a of the control gate 240, contacts (also called contact plugs), which are formed in the subsequent process and respectively disposed on the floating gate 224 and the control gate 240 may have the same height. The thickness of the floating gate 224 is less than the thickness of the control gate 240.

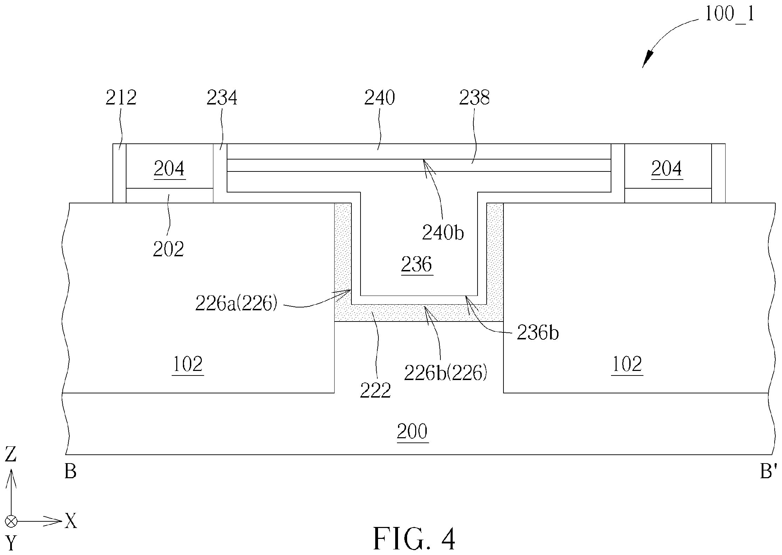

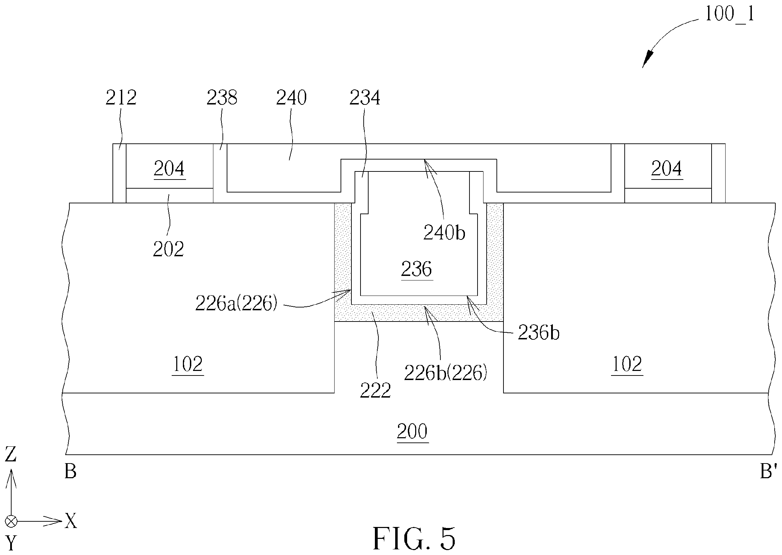

FIG. 4 is a schematic cross-sectional view of a non-volatile memory device taken along line B-B' of FIG. 1 according to some embodiments of the present disclosure. FIG. 5 is a schematic cross-sectional view of a non-volatile memory device taken along line B-B' of FIG. 1 according to an alternative embodiment of the present disclosure. Referring to FIG. 4, the select gate 204 is disposed on the isolation structure 102. The trench 236 and source region 222 are disposed in the substrate 200 between two adjacent portions of the isolation structure 102.

The major portions of the erase gate dielectric layer 234 are disposed in the trench 226. The smaller portions of the erase gate dielectric layer 234 can either extend outside the trench 226 (as shown in FIG. 4) or be confined to the space over the trench 226, with a width that is approximately the same as or narrower than the width of the trench 226(as shown in FIG. 5). Referring to FIG. 4, the portions of the erase gate dielectric layer 234 that are disposed outside the trench 226 may cover the top surface of the isolation structure 102 and the sidewall of the select gate 204. For both structures shown in FIG. 4 and FIG. 5, the bottom surface 240b of the control gate 240 is higher than a bottom surface 236b of the erase gate 236.

The erase gate 236 is filled into the trench 226 and extends outward to partially cover the top surface of the isolation structure 102.

The control gate 240 and the coupling dielectric layer 238 may extend between two adjacent select gates 204, and partially cover the top surface of the isolation structure 102.

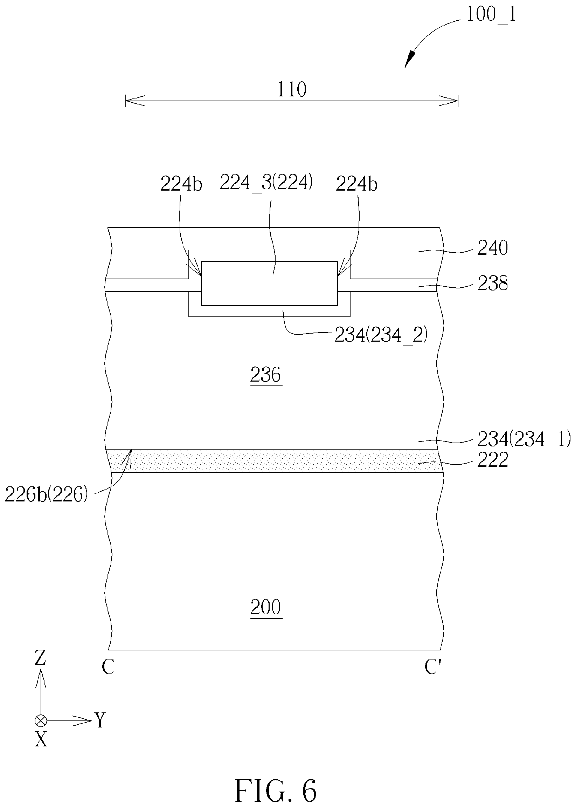

FIG. 6 is a schematic cross-sectional view of a non-volatile memory device taken along line C-C' of FIG. 1 according to some embodiments of the present disclosure. Referring to FIG. 6, the erase gate dielectric layer 234 includes a lower section 234_1 and an upper section 234_2 that are vertically separated from each other by the erase gate 236. Specifically, the lower section 234_1 of the erase gate dielectric layer 234 is located between the source region 222 and the erase gate 236, while the upper section 234_2 of the erase gate dielectric layer 234 is located between the floating gate 224 (also called the lower tip 224_3 of the floating gate 224) and the erase gate 236. The upper section of the erase gate dielectric layer 234 covers the bottom surface and a lower portion of the second sidewall 224b of the lower tip 224_3.

The coupling dielectric layer 238 is located above the upper section of the erase gate dielectric layer 234, and extends continuously along the Y-direction. The coupling dielectric layer 238 covers an upper portion of the second sidewall 224b of the lower tip 224_3.

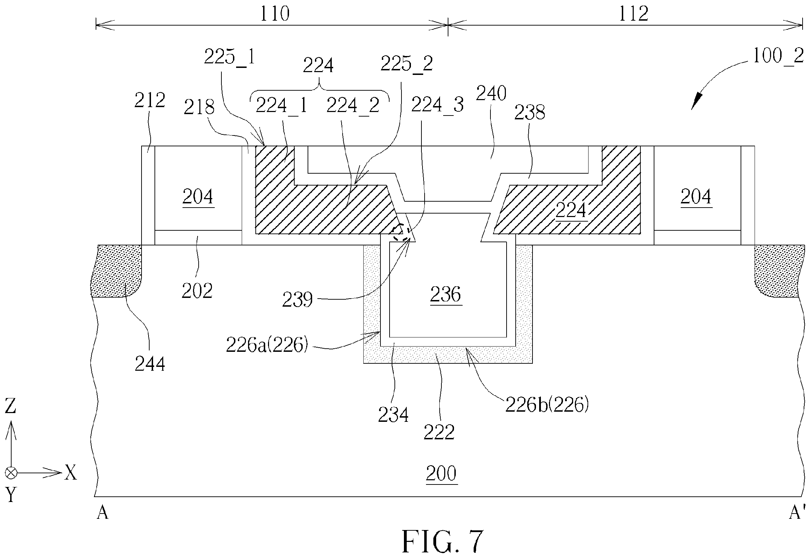

FIG. 7 is a schematic cross-sectional view of a non-volatile memory device according to an alternative embodiment of the present disclosure. The structure shown in FIG. 7 is analogous to the structure shown in FIG. 2, the main difference lies in the shape of the floating gate 224. In a non-volatile memory device 100_2 shown in FIG. 7, the floating gate 224 is not bar-shaped but L-shaped, and includes a vertical portion 224_1 and a horizontal portion 224_2. The vertical portion 224_1 is laterally spaced apart from both the control gate 240 and the select gate 204. The horizontal portion 224_2 is located under the control gate 240 and includes the lower tip 224_3. A top surface 225_2 of the horizontal portion 224_2 is lower than a top surface 225_1 of the vertical portion 224_1. Due to the presence of the vertical portion 224_1, the top surface of the vertical portion 224_1 of the floating gate 224 may be substantially level with the top surfaces of both the control gate 240 and the select gate 204.

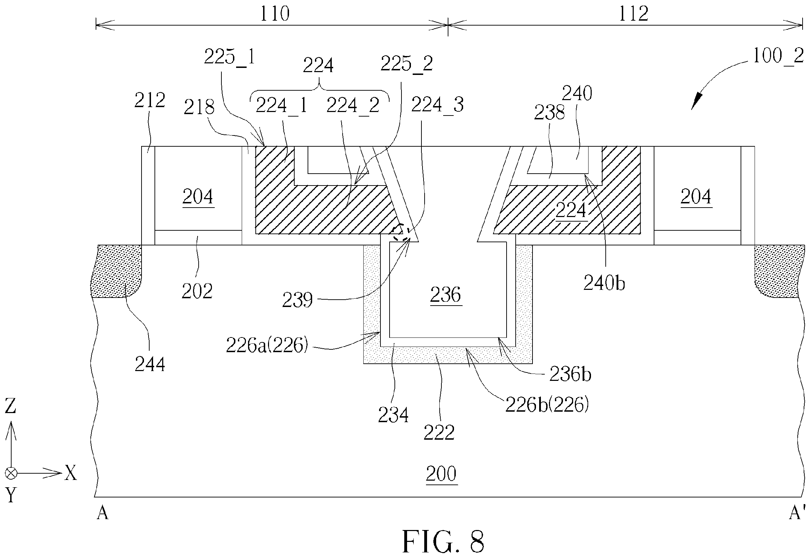

FIG. 8 is a schematic cross-sectional view of a non-volatile memory device according to an alternative embodiment of the present disclosure. The structure shown in FIG. 8 is analogous to the structure shown in FIG. 7, the main difference lies in the shapes and relative locations of the erase gate 236 and the control gate 240. Specifically, in FIG. 8, the top surface of the erase gate 236 is higher than the bottom surface of horizontal portion 224_2 of the floating gate 224, and can be substantially level with the top surface of the select gate 204. Furthermore, a pair of control gates 240 is separated by the upper portion of the erase gate 236 that is located above the trench 226.

As respectively shown in FIG. 7 and FIG. 8, the top surface of the erase gate 236 can be either lower than the top surface 225_2 of the horizontal portion 224_2 of floating gate 224 (as shown in FIG, 7), or can be higher than the top surface 225_2 of the horizontal portion 224_2 of floating gate 224 (as shown in FIG. 8).

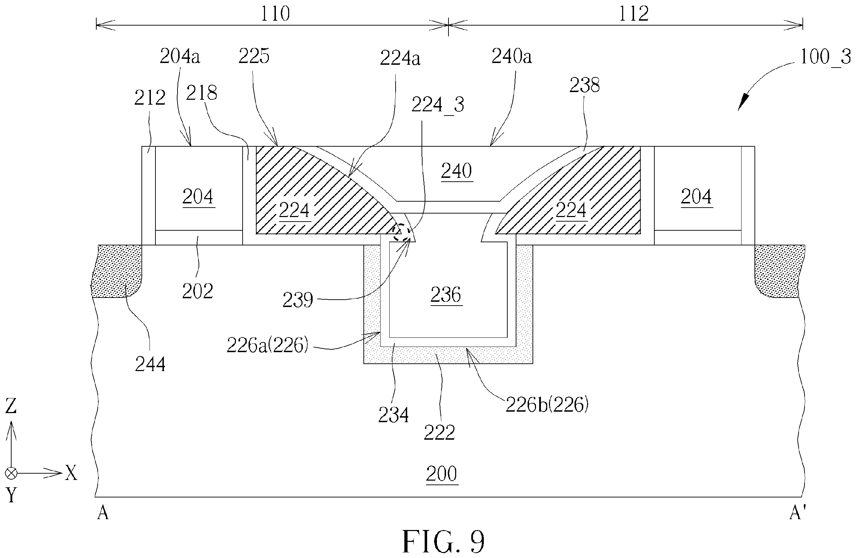

FIG. 9 is a schematic cross-sectional view of a non-volatile memory device according to an alternative embodiment of the present disclosure. The structure shown in FIG. 9 is analogous to the structure shown in FIG. 2, the main difference lies in the shape of the floating gate 224. In a non-volatile memory device 100_3 shown in FIG. 9, the first sidewall 224a of the floating gate 224 that faces the control gate 240 is a curved sidewall instead of a vertical or inclined surface, and an upper portion of the first sidewall 224a is covered with the control gate 240.

Analogously, the top surface 224a of the floating gate 224 may be substantially level with the top surfaces 240a, 204a of both the control gate 240 and the select gate 204.

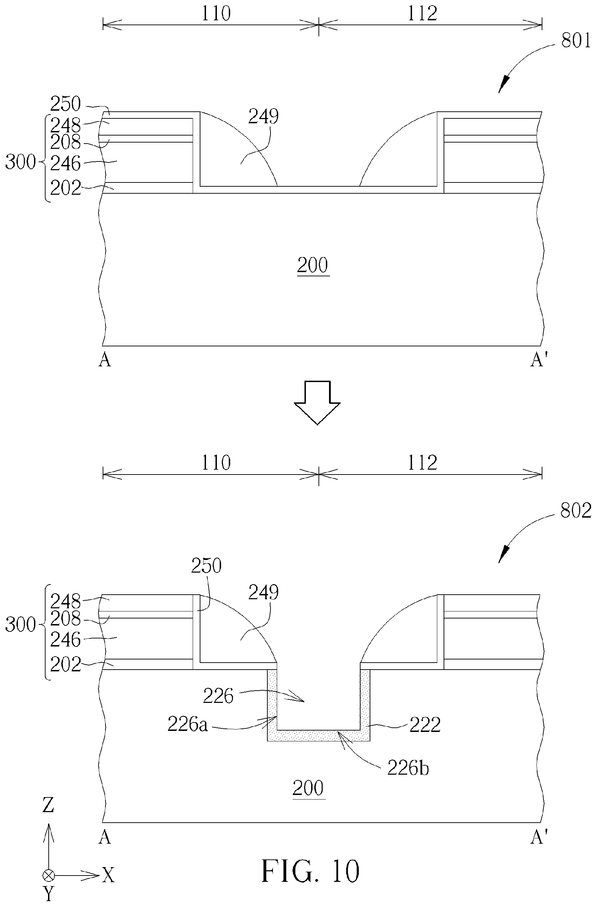

FIG. 10 to FIG. 15 are cross-sectional views at various stages in the manufacturing of non-volatile memory devices, such as those shown in FIGS. 1-4 and 6, according to some embodiments of the present disclosure. In FIG. 10 to FIG. 15, view AA' corresponds to the line A-A' of FIG. 1.

Referring to FIG. 10, in step 801, a substrate 200 is provided. According to some embodiments of the present disclosure, the substrate 200 may be a semiconductor substrate with suitable conductivity type, such as p-type or n-type. The composition of the substrate 200 may include silicon, germanium, gallium nitride or other suitable semiconductor materials, but is not limited thereto.

At least one stacked structure 300 is on the substrate 200. For example, two stacked structures 300 are disposed on the substrate 200 and laterally spaced apart from each other. One of the stacked structures 300 is located in a first memory cell region 110, and the other one is located in a second memory cell region 110. Each of the stacked structures 300 includes a select gate dielectric layer 202, a select gate layer 246, an insulation layer 208, and a top etch mask 248. The top etch mask 248 is a patterned etch mask that is used to define the shape of underlying layers such as the select gate dielectric layer 202 and the select gate layer 246.

Then, a dielectric layer 250 is conformally deposited onto the stacked structures 300 and the substrate 200. The thickness of the dielectric layer 250 is less than the thickness of the select gate layer 246.

After the formation of the dielectric layer 250, two self-aligned etch masks 249 are formed on the sidewalls of the stacked structures 300. The self-aligned etch masks 249 are laterally spaced apart from each other, which may leave the portion of the dielectric layer 250 between the self-aligned etch masks 249 exposed. The self-aligned etch mask 249, which can be made of a dielectric material such as nitride, oxide or oxynitride, forms a stripe extending along the Y-direction in a top-view.

Afterwards, in step 802, by using both the top etch mask 248 and the self-aligned etch mask 249 as an etch mask, an etching process is performed to etch portions of the substrate 200 located between the self-aligned etch masks 249. As a result, a trench 226 which is laterally spaced apart from the select gate layer 246 is formed in the substrate 200. The depth of the trench 226 may be adjusted based on actual requirements.

Then, a source region 222 is formed along a sidewall 226a and a bottom surface 226b of the trench 226. The forming method of the source region 222 includes, for instance, performing an ion implantation process. The implanted dopant can be an n-type or p-type dopant as decided according to the design of the device. The dopants and the doping concentrations of the source region 222 may be adjusted based on actual requirements.

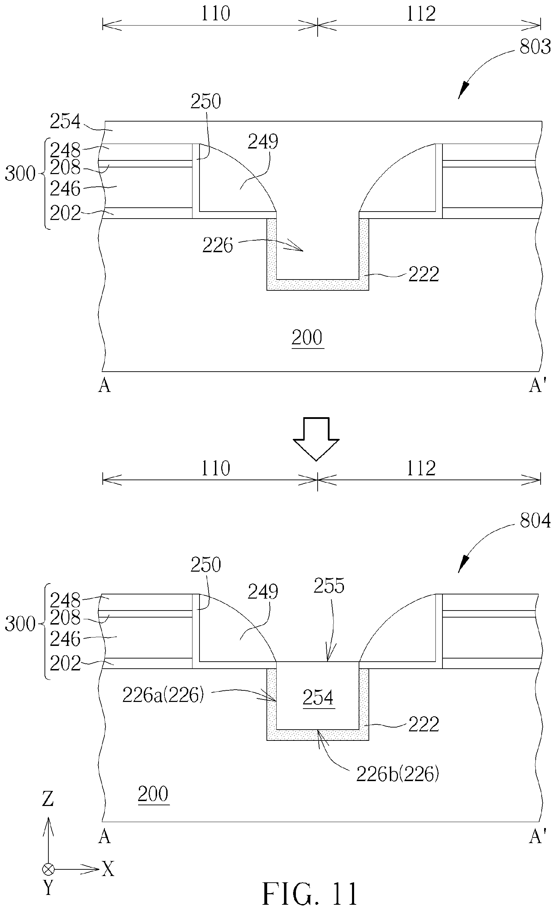

Referring to FIG. 11, in step 803, a filling layer 254 is deposited to cover the stacked structure 300 and the self-aligned etch mask 249. A portion of the filling layer 254 is filled into the trench 226. An optional planarization process can be performed on the filling layer 254 until the filling layer 254 has a substantially flat top surface. The filling layer 254 may be made of an insulating material such as silicon oxide, silicon nitride, silicon oxynitride or other suitable insulating material.

Afterwards, in step 804, an etching back process is performed on the filling layer 254 to remove the portions of the filling layer 254 that are disposed over the stacked structure 300 and the self-aligned etch mask 249. When the etching back process is complete, the trench 226 is still filled with the filling layer 254, and the top surface of the filling layer 254 may be higher than the top surface of the substrate 200 and substantially level with the bottom surface of the self-aligned etch mask 249.

After the steps shown in FIG. 11, the top etch mask 248, the self-aligned etch mask 249, and the dielectric layer 250 may be further removed.

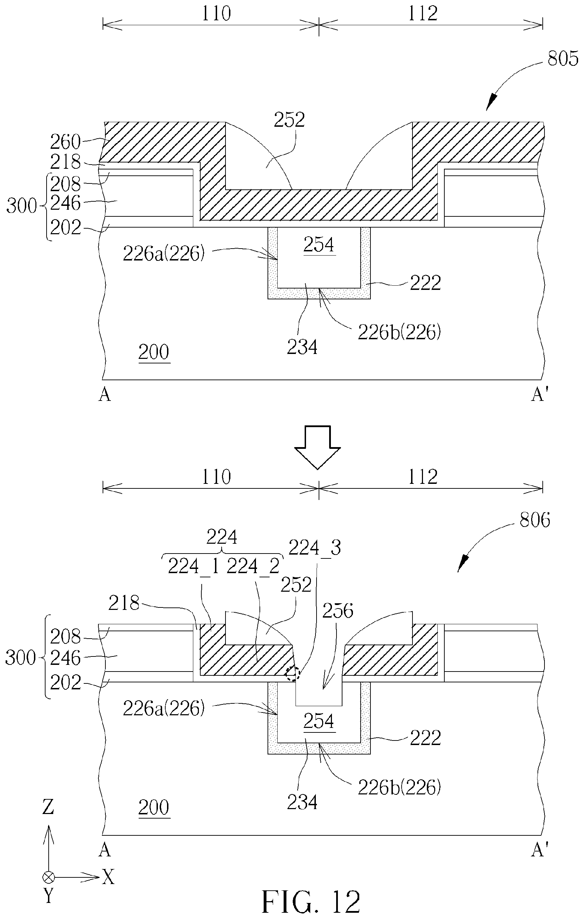

Referring to FIG. 12, in step 805, a floating gate dielectric layer 218 is formed on the substrate 200 to conformally cover the stacked structure 300 and the filling layer 254. The floating gate dielectric layer 218 can be a single dielectric layer including silicon oxide or oxynitride, or a composite dielectric layer including silicon oxide/silicon nitride/silicon oxide, but is not limited thereto. Then, a floating gate layer 260 is deposited on the floating gate dielectric layer 218. The thickness of the floating gate layer 260 can be properly controlled so that the floating gate layer 260 can conform to the shape of the underlying structure. The floating gate layer 260 can be made of a conductive material such as poly silicon or metal, but is not limited thereto.

The floating gate layer 260 may be further patterned to become a structure including several stripe-shaped patterns, and each of the stripe-shaped patterns extends along the X-direction in a top view.

After the formation of the floating gate layer 260 including several stripe-shaped patterns, two self-aligned etch masks 252 are formed on a vertical surface of the floating gate layer 260. The etch mask 252 can be made of dielectric material such as silicon oxide, silicon nitride or oxynitride, but not limited to these materials. The self-aligned etch masks 252 are laterally spaced apart from each other, leaving the portion of the floating gate layer 260 between the self-aligned etch masks 252 exposed. The self-aligned etch mask 252 is a stripe-shaped structure extending along the Y-direction in a top-view. The width of etch mask 252 and the thickness of floating gate 260 are adjusted to ensure that a floating gate edge (as described next) extends beyond the trench sidewall 226a.

As described above, in step 806, by using the self-aligned etch mask 252 as an etch mask, an etching process is performed to etch portions of the floating gate layer 260. As a result, a floating gate 224 including a vertical portion 224_1 and a horizontal portion 224_2 are obtained. The horizontal portion 224_2 of the floating gate 224 includes a lower tip 224_3 located over the trench 226 and extending beyond the sidewall 226a of the trench 226. The floating gate 224 is a self-aligned structure, thus eliminating the need for a photolithography process to define the location of the floating gate 224. Two floating gates 224 may be formed in the first memory cell region 110 and the second memory cell region 112 respectively, and may be laterally separated from each other in the X-direction.

Moreover, during the process of forming the floating gate 224, the portions of the floating gate dielectric layer 218 that are disposed over the select gate layer 246 and the filling layer 254 may be removed. As a result, the insulation layer 208 that is on the select gate layer 246 may be exposed or even completely removed, and the filling layer 254 may be partially etched to include a recess 256.

Afterwards, the filling layer 254 and the portion of the floating gate dielectric layer 218 that cover the bottom surface of the lower tip 224_3 may be further removed, thus exposing the bottom surface of the lower tip 224_3. The self-aligned etch mask 252 can be either subsequently removed or, in an alternative embodiment, left in place during the removal of the filling layer 254. The remaining self-aligned etch mask 252 can be used to confine the subsequently deposited erase gate 234 within a space over the trench 226, with a width that is approximately the same as or narrower than the width of the trench 226.

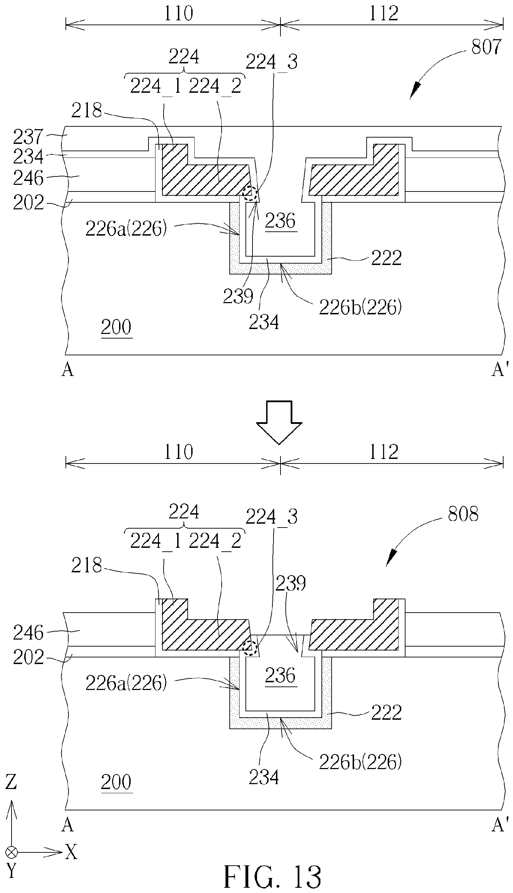

Referring to FIG. 13, in step 807, an erase gate dielectric layer 234 is conformally formed to cover the select gate layer 246, the floating gate 224, the bottom surface of the lower tip 224_3, and the sidewall 226a and bottom surface 226b (also called inner surface) of the trench 226. The thickness of the erase gate dielectric layer 234 is less than the thickness of the floating gate 224. Then, an erase gate layer 237 is deposited to cover the stacked structure 300 and the floating gate 224. A portion of the erase gate layer 237 is filled into the trench 226. Because of the present of the lower tip 224_3 of the floating gate 224, the erase gate layer 237 may have a concave corner 239 corresponding to the location of the lower tip 224_3. An optional planarization process can be performed on the erase gate layer 237 until the erase gate layer 237 has a substantially flat top surface. The erase gate layer 237 may be made of conductive material such as poly silicon or metal, but not limited thereto.

Subsequently, in step 808, an etching back process is performed to remove the portions of the erase gate layer 237 that are disposed over the select gate layer 204 and the floating gate 224. An erase gate 236 may be obtained when the etching back process is complete. The erase gate 236 is filled into the trench 226, and the top surface of the erase gate 236 is higher than the bottom surface of the horizontal portion 224_2. Depending on the shape of the floating gate 224, which can be spacer-shaped, L-shaped, or bar-shaped, the top surface of the erase gate 236 can be lower or higher than the top surface of the horizontal portion 224_2. Therefore, a sidewall of the horizontal portion 224_2 may be partially covered with the erase gate 236.

Then, an etching process is performed to remove the erase gate dielectric layer 234 that is disposed over the select gate layer 246 and the floating gate 224.

When step 808 is complete, the lower tip 224_3 of the floating gate 224 may be covered with the erase gate 236 and the erase gate dielectric layer 234.

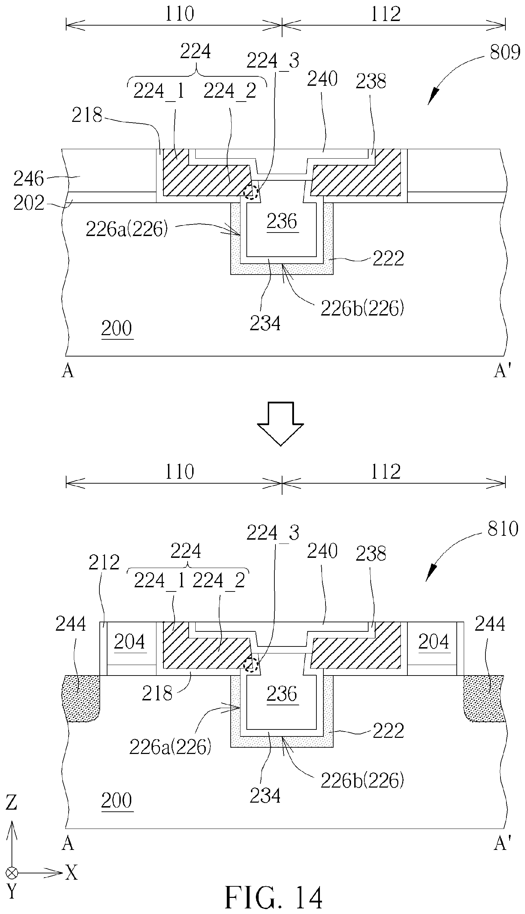

Referring to FIG. 14, in step 809, a coupling dielectric layer 238 and a control gate 240 are formed to cover the horizontal portion 224_2 of the floating gate 224 and the erase gate 236. An upper sidewall of the horizontal portion 224_2 may be covered with the coupling dielectric layer 238 and the control gate 240. An optional planarization process can be performed on the select gate layer 246, the vertical portion 224_1 of the floating gate 224 and the control gate 240 until the top surfaces of the select gate layer 246, the vertical portion 224_1, and the control gate 240 are level with each other. The erase gate layer 237 may be made of conductive material such as poly silicon or metal, but not limited thereto.

Afterwards, in step 810, the select gate layer 246 may be patterned to form select gates 204. A dielectric spacer 212 is formed on the sidewall of the select gate 204 in order to insulate the select gate 204 from other conductive components. At least one drain region 244, such as two drain regions 244, may be formed at sides of the select gates 204. The drain regions 244 are disposed in the first memory cell region 110 and the second memory cell region 112 respectively, which can be electrically coupled to each other through vias or contacts in the subsequent manufacturing processes.

The forming method of the drain region 244 includes, for instance, performing an ion implantation process. The implanted dopant can be an n-type or p-type dopant as decided according to the design of the device. The dopants and the doping concentrations of the source region 222 and the drain region 244 can be the same and can also be different.

Afterwards, other electronic components can be manufactured by performing suitable manufacturing processes so as to obtain a non-volatile memory device similar to the structure shown in FIG. 1 and 7.

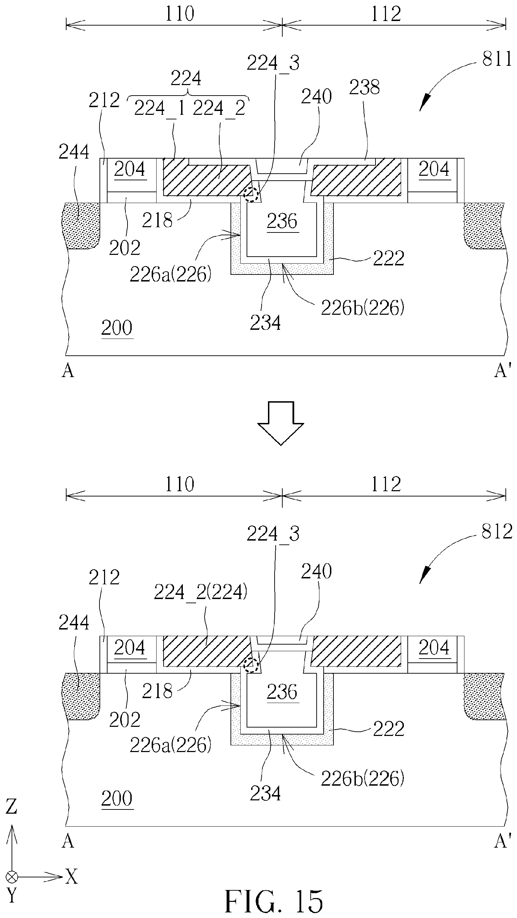

Referring to FIG. 15, in step 811, in order to further reduce the height of the memory device in the first and second memory cell regions 110, 112, an additional planarization process can be performed on the select gate 204, the vertical portion 224_1 of the floating gate 224, and the control gate 240 until the coupling dielectric layer 238 disposed over the horizontal portion 224_2 of the floating gate 224 is exposed. When the planarization process is complete, almost all the vertical portion 224_1 is removed.

In addition, the height of the memory device in the first and second memory cell regions 110, 112 may be further reduced in order to fulfill strict design requirements. In step 812, an additional planarization process can be performed on the select gate 204, the vertical portion 224_1 of the floating gate 224, and the control gate 240 until the coupling dielectric layer 238 disposed over the top surface of the horizontal portion 224_2 of the floating gate 224 is removed. When the planarization process is complete, the entire vertical portion 224_1 of the floating gate 224is removed. Consequently, the top surfaces of the select gate 204, the control gate 240, and the floating gate 224 are level with each other.

Afterwards, other electronic components can be manufactured by performing suitable manufacturing processes so as to obtain a non-volatile memory device similar to the structures shown in FIGS. 1-4 and 6.

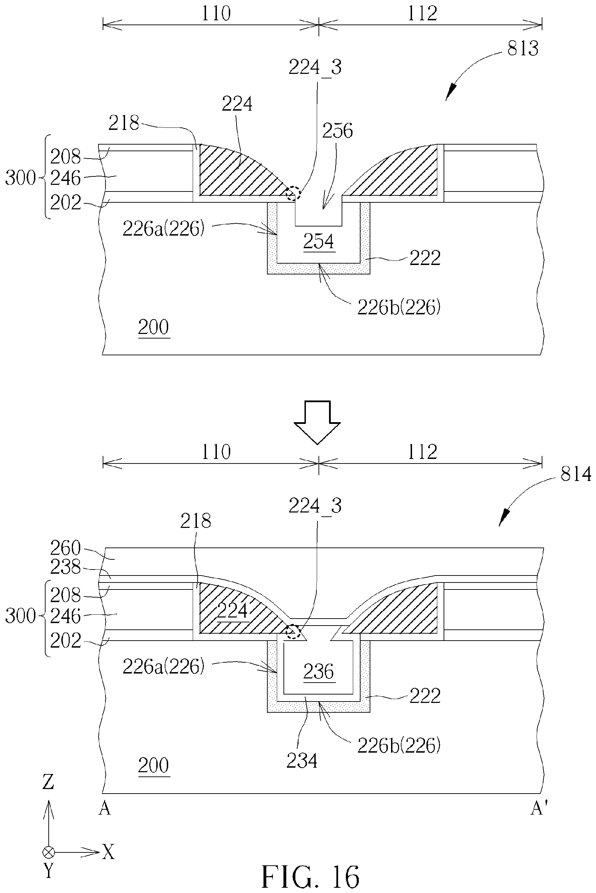

FIG. 16 is a schematic cross-sectional view at various stages in the manufacturing of non-volatile memory devices, such as those shown in FIGS. 1 and 6, according to an alternative embodiment of the present disclosure. In FIG. 16, view AA' corresponds to the line A-A' of FIG. 1. Some of the manufacturing processes of the embodiments shown in FIGs. 10-15 may be replaced with or modified by the manufacturing processes shown in FIG. 16, and only the main differences between the embodiments are described for the sake of brevity.

Referring to FIG. 16, the manufacturing stage in step 813 is analogous to that in step 806, the main difference lies in the shape of the floating gate 224. In step 813, the floating gate 224 is a self-aligned structure formed by etching a conductive layer such as a floating gate layer. The floating gate 224 has a curved sidewall, a top tip, and a lower tip 224_3

After the formation of the erase gate dielectric layer 234 and the erase gate 236 analogous to those shown in FIG. 13-FIG. 14, in step 814, a coupling dielectric layer 238 is deposited to cover the curved sidewall of the floating gate 224 and a top surface of the erase gate 236. Then, a control gate layer 260 is deposited to cover the coupling dielectric layer 238, and the control gate layer 260 may be further planarized to form the control gate layer 240 as shown in FIG. 9.

Other manufacturing processes analogous to those shown in FIGs. 10-15 may be performed so as to obtain a non-volatile memory device similar to the structures shown in FIG. 9.

In some embodiments, referring to FIGs. 10-16, a method for manufacturing a non-volatile memory device is provided and includes the following steps: providing a substrate 200;forming a trench 226 in the substrate 200; forming a floating gate 224 on the substrate 200, where the floating gate 224 comprises a lower tip 224_3 extending beyond a sidewall 226a of the trench 226; forming an erase gate dielectric layer 234 covering the lower tip 224_3 of the floating gate 224 and a sidewall 226a and bottom surface 226b of the trench 226; forming an erase gate 236 in the trench 226 after forming the erase gate dielectric layer 234; and forming a control gate 240 forming the erase gate 236, where a bottom surface 240b of the control gate 240 is higher than a bottom surface 236b of the erase gate 236

In some embodiments, referring to FIGs. 10-16, the method for manufacturing the non-volatile memory device further includes: forming a select gate layer 246 laterally spaced apart from the erase gate 236 and floating gate 224; and planarizing a top surface 204a of the select gate layer 246, a top surface 240a of the control gate 240, and a top surface 225 of the floating gate 224 until the top surfaces of the select gate layer 246, the control gate 240, and the floating gate 224 are level with each other.

In some embodiments, referring to FIGs. 10-16, the method for manufacturing the non-volatile memory device further includes: forming a filling layer 254 in the trench 226 before forming the floating gate 224 on the substrate 200; forming the floating gate 224 on the filling layer 254 when forming the floating gate 224 on the substrate 200; and exposing a bottom surface 224d of the lower tip 224_3 of the floating gate 224 before forming the erase gate dielectric layer 234.

In some embodiments, referring to FIGs. 10-16, in the method for manufacturing the non-volatile memory device, a bottom surface 224d of the lower tip 224_3 of the floating gate 224 is covered with the erase gate dielectric layer 234 before forming the erase gate 236 in the trench 226.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A non-volatile memory device (100_1, 100_2, 100_3), **characterized by** at least one memory cell, wherein the at least one memory cell comprises:
a substrate (200);
a trench (226) disposed in the substrate (200);
an erase gate (236) disposed in the trench (226), wherein the erase gate (236) comprises a concave corner (239);
a control gate (240) disposed on the substrate (200), wherein a bottom surface (240b) of the control gate (240) is higher than a bottom surface (236b) of the erase gate (236); and
a floating gate (224) disposed on the substrate (200), wherein the floating gate (224) comprises a lower tip (224_3) pointing toward the concave corner (239) of the erase gate (236), and the lower tip (224_3) extending beyond a sidewall (226a) of the trench (226).

2. The non-volatile memory device (100_1, 100_2, 100_3) of claim 1, wherein a bottom surface (224c) of the floating gate (224) is higher than a bottom surface (236b) of the erase gate (236).

3. The non-volatile memory device (100_1, 100_2, 100_3) of any one of claims 1-2, wherein a top surface (225, 225_1) of the floating gate (224) is higher than a top surface (236a) of the erase gate (236) and/or level with a top surface (240a) of the control gate (240).

4. The non-volatile memory device (100_1, 100_2, 100_3) of any one of claims 1-3, wherein the lower tip (224_3) is disposed over the trench (226).

5. The non-volatile memory device (100_1, 100_2, 100_3) of any one of claims 1-4, further comprising a coupling dielectric layer (238) disposed between the top surface (236a) of the erase gate (236) and a bottom surface (240b) of the control gate (240).

6. The non-volatile memory device (100_1, 100_2, 100_3) of any one of claims 1-5, further comprising a source region (222) disposed in the substrate (200), wherein the source region (222) is disposed along a sidewall (226a) and bottom surface (226b) of the trench (226).

7. The non-volatile memory device (100_1, 100_2, 100_3) of any one of claims 1-6, further comprising an erase gate dielectric layer (234) disposed between the lower tip (224_3) and the erase gate (236).

8. The non-volatile memory device (100_1, 100_2, 100_3) of claims 7, wherein the erase gate dielectric layer (234) conformally covers the lower tip (224_3), and the erase gate dielectric layer (234) is in direct contact with a bottom surface (224d) of the lower tip (224_3).

9. The non-volatile memory device (100_1, 100_2, 100_3) of claim 7 or 8, wherein the erase gate dielectric layer (234) is further disposed on a sidewall (226a) and bottom surface (226b) of the trench (226).

10. The non-volatile memory device (100_1, 100_2, 100_3) of any one of claims 7-9, further comprising a floating gate dielectric layer (218) disposed between the floating gate (224) and the substrate (200), wherein an end of the floating gate dielectric layer (218) is in direct contact with the erase gate dielectric layer (234).

11. The non-volatile memory device (100_1, 100_2, 100_3) of any one of claims 1-10, wherein the floating gate (224) further comprises:
two first sidewalls (224a) each extending along a first direction; and
two second sidewalls (224b) opposite each other and arranged along a second direction different from the first direction,
wherein the control gate (240) extends along the second direction and covers an upper portion of each of the second sidewalls (224b) of the floating gate (224).

12. The non-volatile memory device (100_1, 100_2, 100_3) of claim 11, wherein the erase gate (236) extends along the second direction and covers a lower portion of each of the second sidewalls (224b) of the floating gate (224).

13. The non-volatile memory device (100_1, 100_2, 100_3) of any one of claims 1-12, further comprising a select gate (204) laterally spaced apart from the erase gate (236), and a top surface (204a) of the select gate (204) is higher than the top surface (236a) of the erase gate (236).

14. The non-volatile memory device (100_2) of any one of claims 1-13, wherein the floating gate (224) further comprises:
a horizontal portion (224_2) disposed under the control gate (240) and comprising the lower tip (224_3); and
a vertical portion (224_1) laterally spaced apart from the control gate (240),
wherein a top surface (225_2) of the horizontal portion (224_2) is lower than a top surface (225_1) of the vertical portion (224_1).

15. The non-volatile memory device (100_3) of claim 11, wherein one of the first sidewalls (224a) is a curved sidewall covered with the control gate (240).
